## Europäisches Patentamt
## European Patent Office
## Office européen des brevets

(19)

(11) Numéro de publication: **0 064 025**
**B1**

(12) **FASCICULE DE BREVET EUROPEEN**

(45) Date de publication du fascicule du brevet:
**14.08.85**

(51) Int. Cl.⁴: **G 04 G 5/04, H 03 K 17/94**

(21) Numéro de dépôt: **82810154.3**

(22) Date de dépôt: **07.04.82**

(54) **Montre électronique à organe de commande fixe.**

(30) Priorité: **22.04.81 CH 2624/81**

(43) Date de publication de la demande:
**03.11.82 Bulletin 82/44**

(45) Mention de la délivrance du brevet:
**14.08.85 Bulletin 85/33**

(84) Etats contractants désignés:
**DE FR GB**

(56) Documents cités:
**CH - A - 607 872**
**DE - A - 2 814 934**
**DE - A - 2 824 399**
**DE - A - 2 855 935**
**FR - A - 2 286 375**
**GB - A - 2 017 297**
**US - A - 3 823 551**
**US - A - 3 832 056**

(73) Titulaire: **ASULAB S.A., Faubourg du Lac 6,**
**CH-2502 Bienne (CH)**

(72) Inventeur: **Chau, Ngoc Bui, Port Roulant 12,**
**CH-2000 Neuchatel (CH)**
Inventeur: **Simonet, Daniel, Chemin du Pré-de-Lus 4,**
**CH-1258 Perly-Certoux (CH)**

(74) Mandataire: **Dronne, Guy et al, ASUAG Département**
**Brevets et Licences Faubourg du Lac 6, CH-2501 Bienne**
**(CH)**

ACTORUM AG

# Description

La présente invention se rapporte aux montres électroniques; elle concerne, plus particulièrement, une montre électronique à organe de commande fixe.

Un moyen de commande souvent utilisé en horlogerie électronique est le contact électrique actionné par un organe de commande mobile, tel qu'un poussoir ou une couronne. Cette solution nécessite l'emploi d'une élément traversant la boîte de la montre, lequel impose des limitations constructives, diminue la fiabilité et augmente le prix de fabrication du produit. D'autre part, le nombre de commandes, donc celui des contacts et des organes de commande nécessaires, augmente avec le nombre des fonctions de la montre. Le problème de la commande des montres ayant beaucoup de fonctions devient ainsi rapidement critique car, pour des raisons évidentes d'économie et d'esthétique, il n'est guère possible d'utiliser plus de quatre organes de commande. L'emploi de codes, impliquant des séquences dans la manipulation des contacts a permis de surmonter cet obstacle au prix de la mémorisation de manipulations toujours plus complexes.

L'introduction dans les montres de capteurs capacitifs, déjà connus en soi, comme organes de commande a permis d'éliminer certains problèmes posés par les organes de commande mobiles et de concevoir des dispositifs d'entrée de données s'écartant des voies conventionnelles. Par exemple, comme cela est décrit dans la communication no 8 faite par J.P. Jaunin au 55e Congrès de la Société suisse de chronométrie en octobre 1980, l'utilisation de quatre capteurs capacitifs disposés en ligne permet, dans une montre digitale, de corriger l'heure ou d'introduire une heure de réveil très simplement. A cet effet, la montre est mise en état de correction à l'aide d'un poussoir électrique, puis l'information affichée est modifiée en déplaçant un doigt suivant la ligne joignant les centres des quatre capteurs capacitifs disposés sur le boîtier ou la glace de la montre. Le chiffre affiché est augmenté ou diminué, suivant le sens de déplacement du doigt, et sa variation est d'une unité pour chaque passage du doigt sur un capteur. Un mouvement complet, balayant les quatre capteurs, fait donc varier l'affichage de quatre unités. Comme ce mouvement peut être effectué rapidement, une correction, même importante, devient très aisée. Le nombre des capteurs peut être quelconque, mais égal au moins à trois, si le sens du déplacement du doigt doit être déterminé.

Si l'utilisation des capteurs capacitifis à des fins de commande est connue depuis longtemps, par exemple dans les ascenseurs, les appareils de radio et de télévision, leur application aux montres est récente. Cela tient, tout d'abord, au fait qu'un capteur est formé par une électrode dont la surface doit être importante (de l'ordre de celle de la partie du doigt qui vient l'activer) pour assurer un fonctionnement fiable et peu sensible aux parasites industriels. De plus, cette électrode devant se trouver sur la glace de la montre ou sur une partie isolante de la face avant du boîtier, sa liaison électrique avec le circuit, fixé sur un module, pose un problème de construction difficile.

Pour pouvoir utiliser des capteurs de surface réduite, il est nécessaire d'employer des circuits électroniques élaborés, permettant de détecter avec sécurité la faible variation de capacité résultant de l'activation du capteur capacitif. Le brevet suisse no 607872 du Centre Electronique Horloger décrit un tel circuit dans lequel il est fait usage de la détection synchrone d'une tension appliquée à l'électrode du capteur. L'amplitude de la tension détectée varie alors suivant que le capteur est activé ou non. Le risque d'un fausse information due au bruit provoqué par les parasites industriels de 50 et 100 Hz est d'autant plus faible dans ce circuit, que la fréquence de la tension appliquée au capteur est élevée. Avec une fréquence appliquée d'environ 8 kHz et une réalisation soignée, la fiabilité de fonctionnement peut être bonne. L'application de cette tension de 8 kHz sur le capteur entraîne cependant une consommation supplémentaire, voisine de celle du circuit d'une montre à affichage digital par cristaux liquides.

La présente invention a pour but principal de fournir une montre électronique utilisant un organe de commande fixe qui présente l'avantage, par rapport aux capteurs capacitifs, d'être insensible aux parasites électriques de toute nature, d'avoir une très faible consommation de courant et de pouvoir être monté directement sur le module de la montre.

Pour atteindre ce but, la montre selon l'invention, qui comporte un circuit garde-temps; un dispositif d'affichage du temps, commandé par ledit circuit; des moyens de commande manuelle pour fournir des signaux de commande audit circuit; et une source électrique d'alimentation du circuit garde-temps, du dispositif d'affichage et des moyens de commande, est principalement remarquable en ce que lesdits moyens de commande comportent un ensemble formant capteur photo-électrique disposé pour recevoir la lumière ambiante et forunissant un signal représentatif de l'intensité de ladite lumière et dont l'éclairement peut être interrompu manuellement pour générer lesdits signaux de commande.

L'avantage résultant de l'utilisation d'un ensemble formant capteur photo-électrique provient du fait qu'un tel capteur est, par nature, insensible aux parasites électriques, que le signal électrique qu'il fournit ne demande aucune énergie électrique étant produit par la lumière reçue par sa surface sensible et, qu'enfin, il peut être placé en face d'une fenêtre pratiquée dans la carrure de la boîte de la montre, sur le même module que le circuit, auquel il peut être connecté facilement.

De façon avantageuse, lesdits moyens de commande comportent, de plus, un circuit de compensation connecté pour recevoir le signal fourni par l'ensemble formant capteur photo-électrique et permettant de générer lesdits signaux de commande de manière sensiblement indépendante de l'intensité de la lumière ambiante.

D'autres caractéristiques d'une réalisation particulière de la présente invention ressortiront de la description qui va suivre, faite en regard des dessins annexés et donnant, à titre explicatif mais nullement limitatif, une forme de réalisation d'une telle montre. Sur ces dessins:

— la figure 1 est une vue schématique partielle d'une montre à capteur photo-électrique;

— la figure 2 représente la montre vue du côté où se trouvent les fenêtres des capteurs photo-électriques;

— la figure 3 donne les caractéristiques typiques d'une photo-diode;

— la figure 4 représente le circuit d'une montre pourvue d'une commande photo-électrique;

— la figure 5 représente les signaux logiques dérivés du diviseur principal du circuit de la montre;

— la figure 6 représente le schéma d'une forme d'exécution du circuit de commande associé au capteur photo-électrique; et

— la figure 7 représente le schéma d'une autre forme d'exécution du circuit de commande où les capteurs sont mis en série de façon à rendre possible le recharge de la batterie;

— la figure 8 représente une variante de la commande de l'affichage de la montre;

— la figure 9 représente un circuit de sélection de modes de fonctionnement d'une montre.

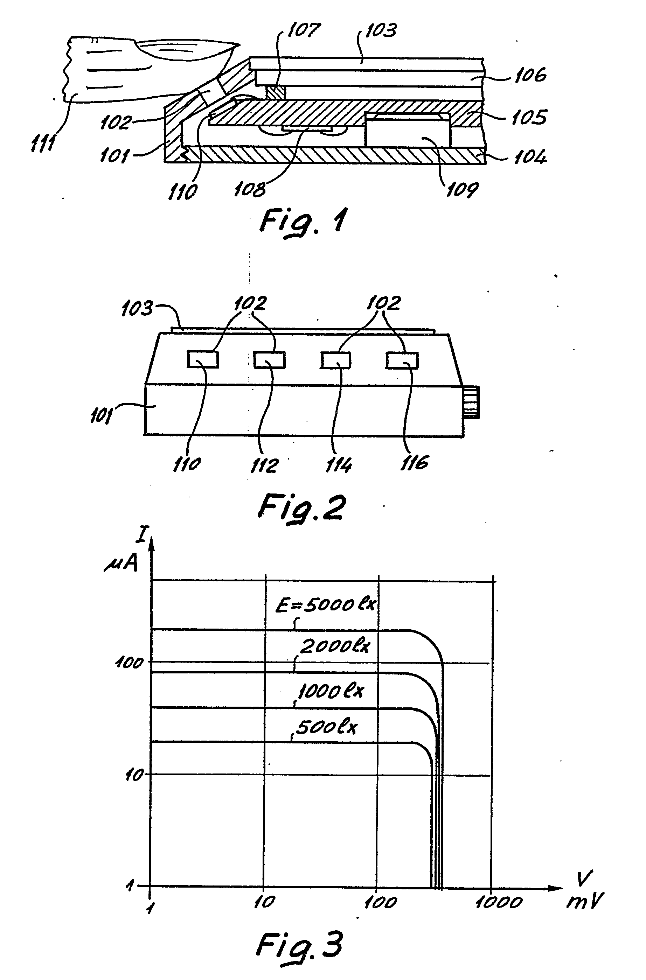

La figure 1 représente schématiquement une vue en coupe du boîtier d'une montre-bracelet comportant une carrure 101, pourvue d'une fenêtre 102 sur sa partie frontale, une glace 103 et un fond 104. A l'intérieur du boîtier se trouve un module 105, fixé à la carrure 101 par des moyens non représentés, un affichage 106, par exemple à cristaux liquides, un connecteur 107 reliant l'affichage au module, un circuit intégré 108, une batterie 109 et un capteur photo-électrique 110 formé d'une photo-diode ou d'une cellule solaire, délivrant un signal électrique en réponse à la lumière qu'il reçoit.

Le capteur 110, qui constitue l'élément sensible de la commande, est placé en face de la fenêtre 102, de façon à ne recevoir la lumière extérieure que par cette voie. Il est monté directement sur le module 105, auquel il est relié électriquement. Cette possibilité de monter le capteur photo-électrique sur le module représente un avantage important par rapport à l'utilisation d'un capteur capacitif qui nécessite une connexion entre le module et l'électrode (fixée sur la glace ou le boîtier).

La figure 2 représente une autre vue de la montre selon la figure 1 avec la carrure 101, la glace 103 et, dans le cas de ce dessin, quatre fenêtres identiques à la fenêtre 102 derrière lesquelles sont disposés quatre capteurs photo-électriques 110, 112, 114 et 116. Le nombre des fenêtres et des capteurs peut naturellement être quelconque.

Le capteur photo-électrique le plus souvent utilisé est une photo-diode, appelée aussi cellule solaire. Elle est constituée par une jonction dans un matériau semi-conducteur ayant une surface sensible d'environ 10 mm² et possède deux bornes de sortie correspondant à sa cathode et à son anode. La figure 3 représente les caractéristiques typiques d'une photo-diode. Elles expriment la relation qui existe entre le courant I qui traverse la photo-diode, sous une tension V entre ses bornes, et l'éclairement E de sa surface sensible, exprimé en lux. Si la cellule débite sur une résistance R, la variation de courant est transformée en une variation de tension, égale au moins à la variation intrinsèque produite par la diode lorsque la résistance a une valeur infinie. Comme une photo-diode n'est sensible qu'à la lumière, un autre avantage de la présente invention, par rapport à une commande utilisant des capteurs capacitifs, est sa parfaite insensibilité aux perturbations électriques de toute sorte.

Si le porteur de la montre obstrue l'une des fenêtres 102 avec un doigt 111, comme cela est représenté sur la figure 1, le capteur correspondant passe de l'état éclairé à l'état obscurci. Les signaux résultants recueillis sur ses bornes servent à former des signaux de commande pour la montre.

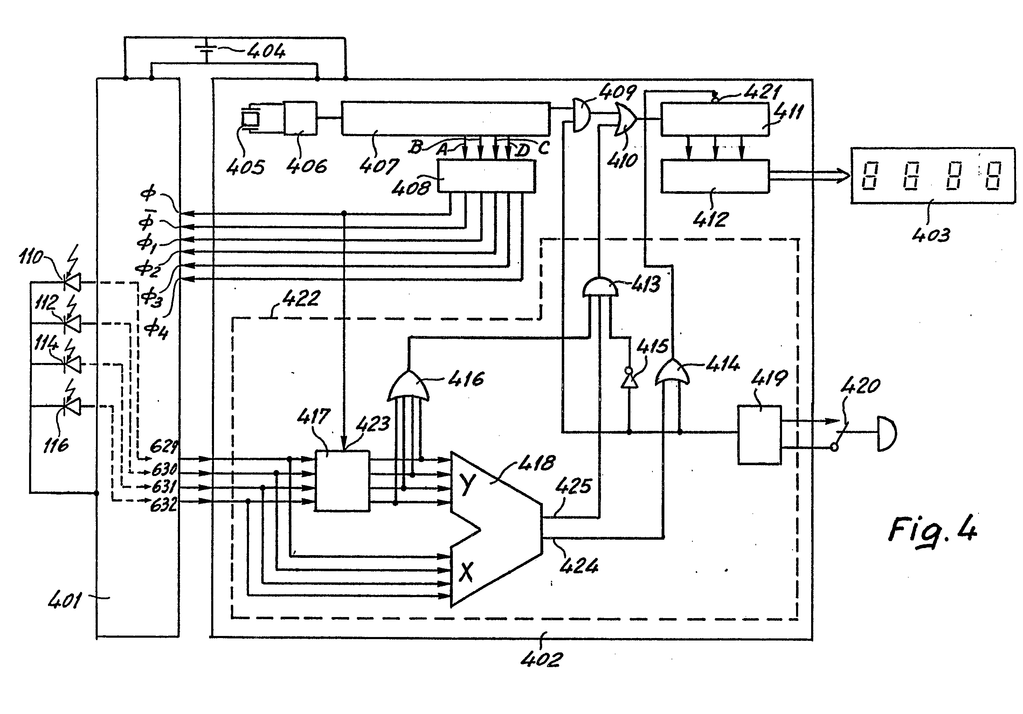

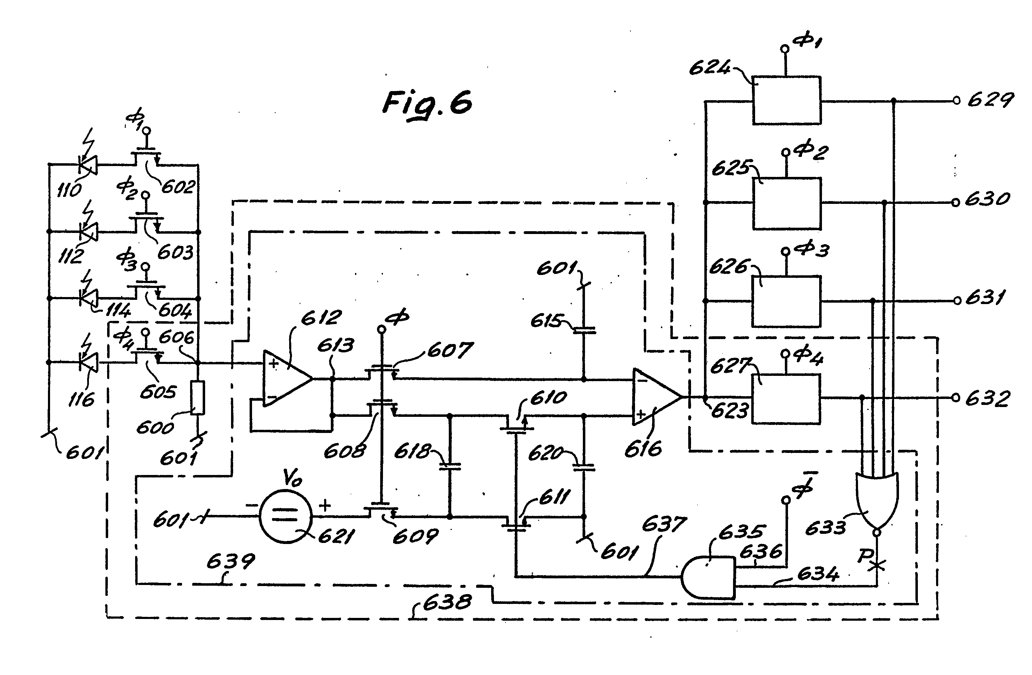

La figure 4 représente le schéma général d'une montre selon l'invention. Les capteurs 110, 112, 114 et 116 sont reliés à un circuit de commande 401 qui sera décrit en détail ultérieurement à l'aide de la figure 6.

En réponse aux signaux produits par les capteurs 110, 112, 114 et 116, le circuit 401 génère des signaux logiques de commande 629, 630, 631 et 632. Ces signaux apparaissent sur des sorties de même nom et sont appliqués à un circuit garde-temps 402. L'obscurcissement, par exemple par un doigt, des capteurs 110, 112, 114 et 116 fait passer respectivement les signaux de commande 624, 630, 631 et 632 à un niveau logique haut. Le circuit, garde-temps 402 élabore, d'une part, des signaux logiques $\Phi$, $\bar{\Phi}$, $\Phi_1$, $\Phi_2$, $\Phi_3$ et $\Phi_4$ nécessaires au circuit 401 et, d'autre part, attaque un affichage digital 403 destiné à indiquer l'heure.

L'alimentation des circuits 401 et 402 est assurée par une pile 404. Enfin un contact électrique 420, actionné par un poussoir, sert à choisir le mode de fonctionnement de la montre.

Le circuit garde-temps 402 va maintenant être décrit en détail. Un résonateur à quartz 405 est entretenu en oscillation par un circuit 406 pour former une base de temps dont le signal de sortie attaque un diviseur de fréquence 407. Des signaux logiques A, B, C et D, dont les fréquences respectives sont typiquement de 128 Hz, 64 Hz, 32 Hz et 16 Hz, sont dérivés du diviseur 407.

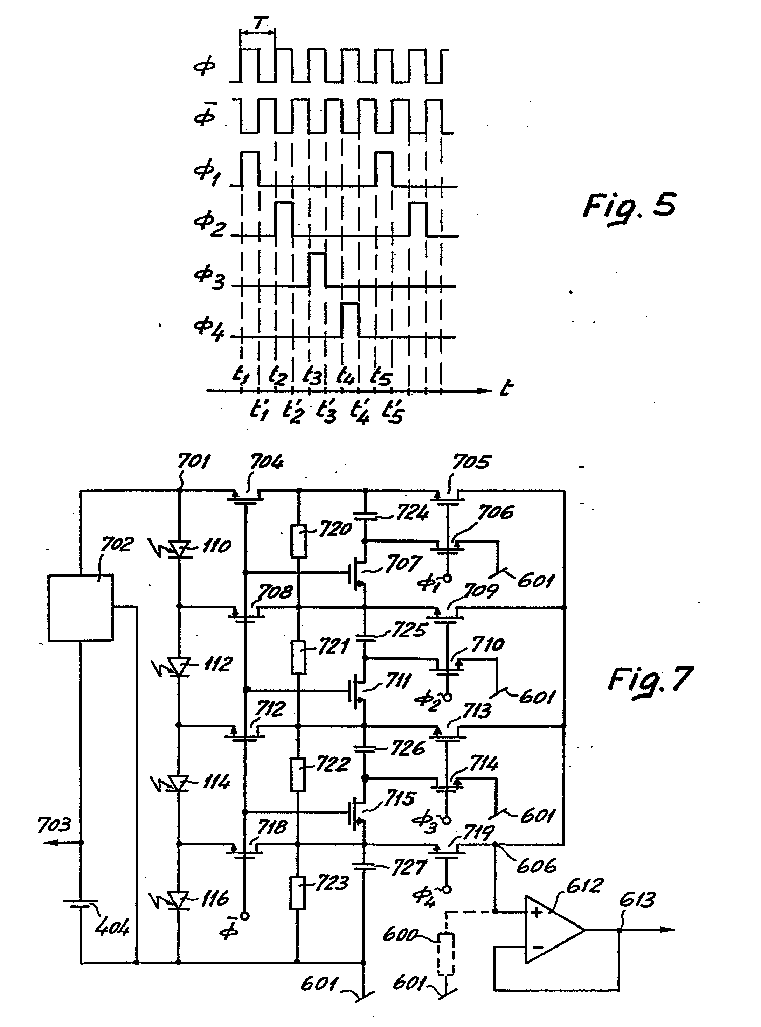

Un circuit logique 408 composé d'un inverseur et de portes ET (non représentés), permet d'élaborer, à partir des signaux A, B, C et D, de signaux $\Phi$, $\bar{\Phi}$, $\Phi_1$, $\Phi_2$, $\Phi_3$ et $\Phi_4$, lesquels sont représentés sur le diagramme de la figure 5. Les signaux A et $\Phi$, de forme carrée, sont identiques et ont une période de 7,8 ms; le signal $\bar{\Phi}$, est un signal en opposition de phase avec le signal $\Phi$; le signal $\Phi_1$, formé d'impulsions rectangulaires positives de 3,9 ms de durée, a une période égale à quatre fois celle du signal $\Phi$, soit 31,25 ms; les signaux $\Phi_2$, $\Phi_3$ et $\Phi_4$ sont identiques u signal $\Phi_1$, sauf qu'ils sont déphasés par rapport à ce dernier, respectivement de une, deux et trois périodes su signal Φ. Ces signaux logiques sont nécessaires au fonctionnement du circuit de commande 401, comme cela apparaîtra par la suite, et le nombre des signaux $\Phi_1$, $\Phi_2$, $\Phi_3$ etc. est égal au nombre de capteur utilisés.

La sortie du diviseur 407 est reliée à l'une des deux entrées d'une porte ET 409 dont la sortie est reliée à son tour à l'une des deux entrées d'une porte OU 410. La sortie de la porte 410 est connectée à l'entrée d'un compteur avant-arrière 411. Ce compteur possède une borne 421 qui détermine, suivant qu'elle est au niveau logique haut ou bas, l'incrémentation ou la décrémentation de son contenu. Un décodeur 412 décode le contenu du compteur 411 et sa sortie attaque l'affichage digital à sept segments 403. Si le niveau logique des autres entrées des portes ET 409 et OU 410 est tel que le compteur 411, dont la borne 421 est supposée être au niveau logique haut, reçoit le signal de sortie du diviseur 407, la montre se comporte de façon conventionnelle en indiquant l'heure.

Un circuit de correction 422 est également incorporé au circuit garde-temps 402 de la figure 4. Il permet de faire une correction de l'heure de la montre à partir des signaux logiques 629, 630, 631 et 632 générés par le circuit de commande 401 en réponse capteurs 110, 112, 114 et 116.

Le passage du mode indication de l'heure au mode correction se fait à l'aide de l'interrupteur 420 qui est relié à un flip-flop 419. Chaque fermeture de l'interrupteur 420 fait basculer le flip-flop 419. Au niveau logique haut de la sortie du flip-flop 419 correspond le mode indication de l'heure, et, au niveau bas, le mode correction de la montre. La sortie du flip-flop 419 est reliée à une entrée d'une porte OU 414 à deux entrées, à l'entrée d'un inverseur 415 et à une entrée de la porte ET 409. La sortie de la porte OU 414 est reliée à la borne 421 du compteur 411. La sortie de l'inverseur 415 est reliée à une entrée d'une porte ET 413 à trois entrées dont la sortie est reliée à une entrée de la porte OU 410. Les sorties des signaux de commande 629, 630, 631 et 632 du circuit 401 sont appliquées à une mémoire 417 à quatre entrées et quatre sorties telle que, par exemple, la mèmoire RCA type 4042. L'entrée d'horloge 423 de cette mémoire 417 est commandée par le signal logique Φ. A chaque niveau logique haut du signal Φ, l'information présente à l'entrée de la mémoire 417 à cet instant est tranférée vers sa sortie et reste mémorisée jusqu'au prochain niveau haut de Φ.

L'état des signaux logiques de commande 629, 630, 631 et 632 du circuit 401 peut être considéré, à un instant donné, comme étant représentatif d'un nombre binaire à 4 bits dans lequel le signal logique 629 correspond, par exemple, au bit le plus significatif. Le nombre binaire, présent à l'entrée de la mémoire 417 sera désigné par X, et le nombre binaire défini par l'état des sorties de cette mémoire au même instant sera désigné par Y. La valeur de Y est ainsi celle qu'avait X, un signal d'horloge Φ plus tôt. Les entrées et les sorties de la mémoire 417 sont reliées à un comparateur 418 ayant deux entrées de quatre bits et deux sorties 424 et 425, comme par exemple le comparateur RCA ype 4063. La sortie 424 prend, par exemple, le niveau logique bas lorsque X est plus grand que Y et le niveau logique haut lorsque X est plus petit que Y. Cette sortie est reliée à une entrée de la porte OU 414. La sortie 425 délivre une impulsion à l'instant où apparaît le signal d'horloge Φ pour autant que x soit différent de Y à ce moment. Cette sortie est reliée à la deuxième entrée de la porte T 413. Enfin, les quatre sorties de la mémoire 417 sont encore reliées aux entrées d'une porte OU 416 dont la sortie est connectée à la troisième entrée de la porte ET 413. La porte OU 416 sert à signaler le valeur zéro du nombre Y en faisant apparaître à sa sortie un niveau logique bas.

Le fonctionnement de la montre en mode correction est déterminé par un niveau logique bas à la sortie du flip-fop 419 de la figure 4, obtenu en actionnant le contact 420. Une des entrées des portes OU 414 et ET 409 est ainsi portée à un niveau logique bas, tandis qu'une entrée de la porte ET 413 est portée à un niveau logique haut, grâce à l'inverseur 415. La porte ET 409 va donc bloquer le signal issu de la sortie du diviseur 407 et arrêter la montre. La sortie de la porte OU 414 permet de mettre le compteur 411 dans l'état d'incrémentation ou de décrémentation, suivant que la sortie 424 du comparateur 418 est au niveau logique haut ou bas.

On considérera maintenant l'état des signaux de commande 629, 630, 631 et 632 du circuit 401. Ces signaux définissent le nombre binaire X. Si les capteurs 110, 112, 114 et 116 reçoivent tous de la lumière, X vaut zéro et, après un signal d'horloge Φ, Y prend la même valeur. Une valeur nulle de Y entraîne un niveau logique bas de la sortie de la porte OU 416. La porte ET 413 est alors bloquée, car une de ses entrées est reliée à la sortie de la porte 416. Si le capteur 112, par exemple, est obscurci à l'aide d'un doigt il génère un signal qui fait passer le signal 630 du circuit de commande 401 au niveau logique haut. Le nombre X passe à cet instant de la valeur zéro à la valeur 0100, alors que Y garde toujours une valeur nulle. La sortie 425 du comparateur 418 délivre un signal, lequel cependant ne parvient pas jusqu'au compteur 411 car, Y étant nul, la porte ET 413 reste fermée. Un signal d'horloge Φ plus tard, Y prend la même valeur 0100 que X. La sortie de la porte OU 416 passe alors au niveau logique haut, ce qui a pour effet d'ouvrir la porte ET 413. Cependant, comme X est égal à Y, aucun signal n'apparaît sur le sortie 425 du comparateur 418.

Si le doigt est alors déplacé du capteur 112 au capteur 114, de façon évidente, X passe de la valeur 0100 à la valeur plus petite 0010, alors que Y garde toujours la valeur 0100. A l'instant du déplacement du doigt d'un capteur au suivant, à l'entrée du comparateur 418, X est inférieur à Y. Un niveau logique haut apparaît ainsi sur la sortie 424 du comparateur 418. Ce niveau logique haut est transmis à travers la porte OU 414 à l'entrée 421 du compteur 411, mettant ce compteur dans l'état d'incrémentation. La sortie 425 du comparateur 418 délivre un signal qui, passant à travers les portes ET 413 et OU 410, incrémente d'une unité le compteur 411. Un signal d'horloge Φ plus tard, Y prendra la même valeur que X, soit 0010. En déplaçant encore le doigt du capteur 114 au capteur 116 de la même manière que précédemment, X passe de la valeur 0010 à la valeur 0001, alors que Y garde la valur 0010. Ceci a pour effet d'incrémenter encore une fois d'une unité le compteur 411.

Par contre, si le déplacement du doigt est fait du capteur 112 au capteur 110, X passe de la valeur 0100 à la valeur plus élevée 1000, tandis que Y reste à la valeur 0100. Comme X est, dans ce cas, supérieur à Y, la sortie 424 du comparateur 418 passe au niveau logique bas, mettant le compteur 411 dans l'état de décrémentation. Le signal qui apparaît sur la sortie 425 du comparateur en réponse à ce mouvement du doigt, va donc décrémenter le compteur 411 d'une unité. Il y a lieu de noter que le bon fonctionnement du circuit 422 requiert que le temps de passage du doigt d'un capteur au suivant soit supérieur à la période du signal logique d'horloge Φ lors d'un mouvement continu du doigt sur une série de capteurs. Dans le cas contraire, en effet, si le signal d'horloge reste au niveau bas pendant ce temps, la mémoire 417 n'enregistrera pas la variation de X.

La description qui vient d'être faite du fonctionnement de la montre en mode correction a permis de mettre en évidence que la valeur indiquée par l'affichage 403 peut être modifiée, en plus ou en moins, par un simple déplacement du doigt, dans un sens déterminé, au-dessus des capteurs 110, 112, 114 et 116.

Le circuit électronique de commande 401 de la figure 4 va maintenant être décrit en détail dans une forme d'exécution préférentielle à l'aide du schéma de la figure 6. Son but est de rendre les signaux logiques de commande qui apparaissent à sa sortie indépendants, dans une large mesure, des variations de la lumière ambiante éclairant les capteurs.

Comme représenté sur la figure 6 les quatre photo-diodes 110, 112, 114 et 116 ont leurs cathodes reliées à un point de masse 601 et leurs anodes respectivement aux drains de quatre transistors 602, 603, 604 et 605 dont les électrodes de commande ou grilles sont reliées au circuit 401 pour en recevoir respectivement les signaux Φ$_1$, Φ$_2$, Φ$_3$ et Φ$_4$. Ces transistors sont des transistors à effet de champ fonctionnant en commutation. Ils se trouvent à l'état bloqué, non passant ou ouvert, lorsque le potentiel de la grille est inférieur ou égal au potentiel de la source. Cela signifie, par exemple, que le transistor 602 est ouvert lorsque le potentiel de Φ$_1$ est égal ou inférieur au potentiel du point 606. L'état saturé, passant ou fermé, est obtenu en appliquant sur la grille un potentiel supérieur à celui de la source. Ces dispositifs se comportent donc comme des interrupteurs. Une résistance 600, branchée entre les points 601 et 606, permet de faire fonctionner chaque capteur 110, 112, 114 et 116 dans des conditions de charge pour lesquelles la variation de tension au point 606 est maximale pour une variation donnée de lumière.

L'entrée directe, marquée par un signe +, d'un amplificateur différentiel 612 est reliée au point 606. L'entrée inverse marquée par un signe − de cet amplificateur est reliée à sa sortie 613 de sorte qu'il se comporte en suiveur de tension de gain unité, ayant une impédance d'entrée élevée et une impédance de sortie basse. Le point 613 est, d'autre part, relié aux drains des deux transistors à effet de champ 607 et 608 fonctionnant en interrupteur. La source du transistor 607 est connectée, d'une part, à une des électrodes d'un condensateur 615 dont l'autre électrode est reliée à la masse 601 et, d'autre part, à l'entrée inverse marquée par un signe −, d'un second amplificateur différentiel 616 ayant un gain G positif. Le gain G est choisi suffisamment élevé pour assurer la saturation de l'amplificateur 616 et permettre à sa sortie 623 de prendre deux niveaux logiques bien définis.

La source du transistor 608 est reliée, d'une part, à une des électrodes d'un second condensateur 618 et, d'autre part, au drain d'un transistor à effet de champ 610 fonctionnant en interrupteur, bornes. Chaque capteur est relié successivement et périodiquement à la résistance 600 à l'aide des interrupteurs 602, 603, 604 et 605, commandés respectivement par ces singaux logiques Φ$_1$, Φ$_2$, Φ$_3$ et Φ$_4$ de la figure 5. Des tensions successives V$_j$ (j = 1 à 4), sensiblement égales entre elles, apparaissent alors au point 606 de la résistance 600. En se reportant à la figure 5, on voit qu'à l'instant t$_1$ les signaux Φ$_1$ et Φ ferment respectivement les interrupteurs 602 et 607, transférant au condensateur 615, par l'intermédiaire de l'amplificateur de gain unité 612, la tension créée à cet instant au point 606 par le capteur 110. A l'instant t'$_1$ les interrupteurs 602 et 607 s'ouvrent, isolant le condensateur 615 qui garde sa charge jusqu'à l'instant t$_2$. A cet instant, les signaux Φ$_2$ et Φ ferment à leur tour les interrupteurs 603 et 607, permettant le transfert au condensateur 615 de la tension produite au point 606 par le capteur 112.

De la même façon les signaux logiques Φ$_3$, Φ$_4$ et Φ vont transférer au condensateur 615, aux instant t$_3$ et t$_4$, les tensions produites par les capteurs 114 et 116, après quoi le cycle recommencera avec les signaux Φ$_1$, Φ et le capteur 110. Le même raisonnement, appliqué au condensateur 618, montre que la tension à ses bornes sera V$_j$−V$_0$ (j = 1 à 4), V$_0$ valant quelques dizaines de mV, aux instants t$_1$, t$_2$, t$_3$ et t$_4$, grâce aux interrupteurs 608 et 609 dont les grilles sont commandées par le signal logique Φ.

Pour la suite de la description du fonctionnement du circuit de commande de la figure 6, on supposera que l'entrée 634 de la porte ET 635 est maintenue à un niveau logique haut après que sa liaison avec la sortie de la porte NON-OU 633 ait été interrompue au point P. La sortie de la porte ET 635, se trouvera alors au niveau logique haut en même temps que le signal Φ̄ appliqué sur l'entrée 636 de cette porte, c'est-à-dire aux ins-

tants $t'_1$, $t'_2$, $t'_3$ et $t'_4$ auxquels, d'autre part, comme on l'a vu, les interrupteurs 608 et 609 sont ouverts. Aux instants $t_1$, $t_2$, $t_3$ et $t_4$ la situation est inverse, les interrupteurs 608 et 609 étant fermés et les interrupteurs 610 et 611 ouverts. Ainsi durant les intervalles de temps allant de $t_1$ à $t'_1$, $t_2$ à $t'_2$, $t_3$ à $t'_3$ $t_4$ à $t'_4$, de durée $T/2$, le condensateur 618 est chargé aux tensions $V_j-V_0$ ($j = 0$ à 4), tandis que durant les intervalles allant de $t'_1$ à $t_2$, $t'_2$ à $t_3$, $t'_3$ à $t_4$, $t'_4$ à $t_5$, également de durée $T/2$, les deux condensateurs 618 et 620 sont connectés en parallèles. Ce fonctionnement correspond à celui d'un réseau à deux condensateurs commutés, dont on sait qu'il simule un filtre passe-bas RC (voir article de J.T. Caves et al. «Sampled analog filtering using switched capacitors as resistor equivalents». IEEE J. Solid-State Circuits vol SC-12, Dec 1977.). En désignant par $C_{618}$ et $C_{620}$ les capacités des condensateurs 618 et 620, la constante de temps du filtre vaut $\tau = T.C_{618}/C_{620}$. Pour une constante de temps $\tau$ de l'ordre de 50 ms, comme T vaut environ 7,8 ms on voit que $C_{618}$ doit être environ 10 fois plus grand que 620. Il résulte de ce filtrage que la tension aux bornes de condensateur $C_{620}$ est égale à la tension moyenne temporelle $\overline{V}$ des tensions $V_j-V_0$ produite par les capteurs dans des conditions d'éclairage ambiant données. Si les capteurs sont identiques et que l'éclairage ambiant est fixe ou varie lentement par rapport à la durée d'environ 32 ms du cycle de mesure des quatre capteurs et de la constante de temps $\tau$ de 50 ms du filtre, ce qui est généralement le cas, on a pratiquement $\overline{V} = V_j-V_0$.

Dans ces conditions, l'amplificateur différentiel 616 de gain G reçoit, sur son entrée directe la tension $\overline{V}$ et, sur son entrée inverse, la tension $V_j$. La tension à sa sortie 623 vaut ainsi $G(\overline{V}-V_j) = -GV_0$. Cette tension est négative et elle correspond à un niveau logique bas. Ce niveau logique est transféré aux mémoires 624, 625, 626 et 627 aux instants, $t_1$, $t_2$, $t_3$ et $t_4$ respectivement par les signaux $\Phi_1$, $\Phi_2$, $\Phi_3$ et $\Phi_4$. Les sorties 629, 630, 631 et 632 de ces mémoires prendront le même état logique bas aux mêmes instants et, étant reliées aux entrées de la porte NON-OU 633 feront apparaître à la sortie de celles-ci un niveau logique haut. C'est précisément ce niveau logique qui était supposé exister sur l'entrée 634 de la porte ET 635 au moment de la coupure au point P de la liaison entre cette entrée et la sortie de la porte NON-OU 633. Cette liaison entre les portes 633 et 635 peut ainsi être rétablie sans perturber le fonctionnement du circuit, lequel, en réponse aux signaux électriques générés par les capteurs éclairés uniformément, élabore donc une tension moyenne $\overline{V}$ aux bornes du condensateur 620, représentative de l'intensité de l'éclairement ambiant.

On examinera maintenant comment réagit le circuit de la figure 6 à une variation très rapide de la lumière ambiante. Si cette variation est faite dans le sens d'un accroissement d'intensité à l'instant $t_1$ par exemple, alors la tension $V_j$ ($j = 1$) augmente jusqu'à une valeur $V'_1$, tandis que la tension $\overline{V}$ reste constante, puisque les interrupteurs 610 et 611 sont ouverts dans l'intervalle de

temps allant de $t_1$ à $t'_1$. La tension à la sortie 623 de l'amplificateur 616 vaut alors $G(V_1-V_0-V'_1)$ et, étant inférieure à $-GV_0$, elle confirme le niveau logique bas déjà existant à l'entrée des mémoires 624, 625, 626 et 627. Le circuit continue donc de fonctionner dans ce cas sans perturbation.

Par contre, si l'intensité lumineuse subit une brusque diminution à l'instant $t_1$, la tension $V_j$ ($j = 1$) baisse jusqu'à la valeur $V'''_1$, alors que $\overline{V}$ reste constant. Une tension $G(V_1-V_0-V'''_1)$ apparaît alors au point 623. Elle peut être positive et donner un niveau logique haut à l'entrée de la mémoire 624 si $V_1$ est supérieur à $V_0+V'''_1$. La sortie 629 de cette mémoire prend le même état, et par conséquent, la porte NON-OU 633 a trois entrées au même niveau logique bas et une entrée logique haut. La sortie de cette porte 633 passe alors au niveau logique bas, entraînant un niveau logique également bas à la sortie 637 de la porte ET 635, quel que soit le niveau logique de $\overline{\Phi}$ sur l'entrée 636. Il en résulte que les interrupteurs 610 et 611 restent ouverts même entre $t'_1$ et $t_2$, entraînant un blocage du circuit. En effet, le condensateur 620 ne peut plus être chargé à la tension correspondant au nouvel éclairement, même après que les sorties des autres mémoires 630, 631 et 632 aient passé au niveau logique haut. Pratiquement, le danger de blocage du circuit est très faible, car il est possible de choisir la tension $V_0$ fournie par le générateur 621 de façon qu'elle soit supérieure à la variation de $V'''_1$ entre $t_1$ et $t'_1$. Si cette condition n'est toutefois pas remplie et que le circuit se bloque, la tension $\overline{V}$ aux bornes du condensateur 620 diminue lentement par suite des courants de fuite inévitables, permettant le redémarrage du circuit après un certain temps.

On considérera maintenant le cas où certains capteurs du circuit de la figure 6 sont volontairement masqués, par exemple par un doigt, dans le but d'introduire dans la montre un signal de commande. On supposera tout d'abord que c'est le capteur 110 qui est brusquement obscurci à l'instant $t_1$. Le signal électrique généré par ce capteur baisse alors d'intensité et fait apparaître une tension $v_1$ aux bornes de la résistance 600, l'interrupteur 602 étant fermé. Cette tension est sensiblement inférieure à la tension $V_1$ qui existait à cet endroit une période de $\Phi_1$ plus tôt, lorsque le capteur 110 était encore pleinement éclairé. Durant l'intervalle de temps allant de $t_1$ à $t'_1$, la tension $v_1$ est transmise au condensateur 615 puisque l'interrupteur 607 est également fermé. Les interrupteurs 610 et 611 étant par contre ouverts, la tension moyenne $\overline{V}$ aux bornes du condensateur 620 correspond à celle qui avait été produite par le plein éclairement de tous les capteurs, et elle vaut pratiquement $V_1-V_0$. Les tensions $v_1$ et $V_1-V_0$ étant appliquées aux entrées de l'amplificateur différentiel 616, il apparaît à sa sortie la tension positive $G(V_1-V_0-v_1)$, car normalement $V_1$ est supérieur à $V_0+v_1$. Cette tension positive correspondant à un niveau logique haut appliqué à l'entrée de la mémoire 624, le même niveau logique se retrouve à la sortie 629. Les autres capteurs 112, 114 et 116, recevant la pleine lumière, il leur correspond un niveau logique bas à la sortie de l'amplificateur 616 et sur les sorties 630, 631, 632 des mémoires 625, 626, 627 pour les mêmes raisons que celles déjà exposées dans le cas de l'éclairage uniforme de tous les capteurs. Par conséquent, une des entrées de la porte NON-OU 633 est à un niveau logique haut, tandis que les autres entrées sont au niveau logique bas. Ceci entraîne un niveau logique bas à la sortie de la porte 633. Cette sortie étant une des entrées de la porte ET 635, la sortie de cette dernière porte prend un niveau logique également bas, quel que soit le niveau du signal logique $\bar{\Phi}$ sur l'entrée 636. Enfin, le niveau logique bas à la sortie de la porte ET 635 met les interrupteurs 610 et 611 dans l'état ouvert.

Il en résulte que, des l'obscurcissement du capteur 110 à l'instant $t_1$, la sortie 629 de la mémoire 624 passe à l'état logique haut, les sorties 630, 631 et 632 des mémoires 625, 626, 627 restant à l'état logique bas. Les interrupteurs 610 et 611 s'ouvrent et isolent le condensateur 620, qui garde en mémoire la tension $\bar{V}$ correspondant à l'éclairement ambiant. Cet état du circuit de commande se maintient aussi longtemps que le capteur 110 n'est pas de nouveau éclairé ou que le condensateur 620 s'est pas déchargé suffisamment par les courants de fuite pour entraîner des niveaux logiques hauts sur les sorties 629, 630, 631 et 632.

Il faut remarquer, d'une part, que le choix de la valeur $V_0$ du générateur 621 résulte d'un compromis entre le danger que le circuit se bloque lors d'une diminution brusque de la lumière ambiante, comme cela avait déjà été examiné dans le cas où $V_0$ est trop faible, et l'inconvénient d'une perte de sensibilité des capteurs si $V_0$ est trop élevé. En effet, un capteur est actif si la grandeur G $(V_1-V_0-v_1)$ devient positive. Cette condition est réalisée si $V_1-v_1$ est supérieur à $V_0$. Or $V_1-v_1$ définit la sensibilité d'un capteur, laquelle est d'autant meilleure que $V_1-v_1$ est petit. Il en résulte que, pour qu'un capteur soit actif et sensible, la tension $V_0$ doit être faible. D'autre part, si l'obscurcissement du capteur 110 intervient à un moment qui tombe en dehors de l'intervalle de temps allant de $t_1$ à $t'_1$ alors le circuit garde son état jusqu'au prochain signal $\Phi_1$ et le processus décrit sera déclenché à partir du temps $t_5$, comme cela est montré sur la figure 5, soit avec un retard maximum de trois périodes et demie du signal $\Phi$, correspondant à environ 27 ms.

Enfin, si plusieurs capteurs sont obscurcis simultanément, par exemple les capteurs 110 et 114, le circuit réagit de façon analogue à celle décrite dans le cas d'un seul capteur obscurci, à l'exception du fait que deux sorties des mémoires, au lieu d'une seule, prendront un état logique haut, à savoir les sorties 629 et 631, les sorties 630 et 632 restant au niveau logique bas. En particulier, l'obscurcissement de tous les capteurs, entraîne un niveau logique haut sur toutes les sorties.

En résumé, le fonctionnement du circuit de commande 401, dont les sorties 629, 630, 631 et 632 correspondent respectivement aux capteurs 110, 112, 114 et 116 reliés à ce circuit, est le suivant. L'éclairement d'un capteur par la lumière ambiante entraîne un niveau logique de commande bas sur la sortie correspondante, tandis que son obscurcissement, c'est-à-dire son activation par un doigt, entraîne un niveau logique haut sur la même sortie. De plus, le circuit est susceptible de fonctionner dans une plage étendue d'eclairement ambiant, grâce à la mesure permanente par les capteurs de son intensité moyenne.

Dans la description du fonctionnement du circuit 401, l'état d'éclairement ou d'obscurcissement des capteurs n'évoluait pas avec le temps. Cela correspond à un fonctionnement statique. Un fonctionnement dynamique est également possible. C'est celui où le doigt du porteur de la montre se déplace de façon à obscurcir les capteurs 110, 112, 114 et 116 dans un certain ordre. La seule condition est que la durée de transition de l'éclairement à l'obscurcissement d'un capteur, ou inversement, soit supérieur à la période des signaux $\Phi_1$, $\Phi_2$, $\Phi_3$ et $\Phi_4$ de façon que le circuit puisse enregistrer ce changement.

Dans le circuit de la figure 6 il y a quatre capteurs 110, 112, 114 et 116 auxquels correspondent respectivement les sorties 629, 630, 631 et 632. Mais il est évident que ce circuit reste utilisable avec un seul capteur. Si l'on considère, par exemple, le capteur 116, la ligne en pointillé 638 délimite la partie du circuit et la sortie 632 qui lui correspondent. Les signaux $\Phi_1$, $\Phi_2$ et $\Phi_3$ ne sont alors plus nécessaires et le signal $\Phi_4$ peut être de même période et de même phase que le signal $\Phi$ de la figure 5. La porte NON-OU 633 n'a plus, de son côté, qu'une entrée, les autres pouvant être considérées comme étant à l'état logique bas. La fonction de cette porte se réduit donc à celle d'une porte NON. L'introduction de plusieurs commandes distinctes dans une montre par un seul capteur ne peut être faite qu'à l'aide d'un code de manipulation. Un circuit dècodeur, comme celui décrit, par exemple, dans la demande de brevet suisse no 617059, doit alors être implanté sur le circuit garde-temps 402 de la montre représentée sur la figure 4 et être reliée à la sortie 632 du circuit de commande 401.

Il faut remarquer que dans le cas de quatre capteurs, le circuit de commande peut être formé de quatre circuits 638, un pour chaque capteur. Cette façon de faire est peu économique en nombre de composants. Une méthode différente, appelée multiplexage, a été utilisée dans la figure 6. Dans ce schéma, un circuit unique 639 peut être isolé entre les capteurs 110, 112, 114, 116 et les mémoires 624, 625, 626, 627. Ce circuit est alors utilisé séquentiellement, d'abord pour lire successivement l'information fournie par chaque capteur, ensuite pour la traiter en vue d'éliminer l'influence des variations de la lumière ambiante et enfin pour la transmettre à la mémoire correspondante. Ceci est réalisé en connectant périodiquement chaque capteur au point commun 606 à l'aide des interrupteurs 602, 603, 604 et 605, commandés respectivement par les signaux logiques $\Phi_1$, $\Phi_2$, $\Phi_3$ et $\Phi_4$, les mêmes signaux commandant également, dans le même ordre, les mémoires 624, 625, 626 et 627 qui mémorisent les informations reçues et les font apparaître sous forme de signaux de commande sur les sorties 629, 630, 631 et 632.

La disposition des capteurs photo-électriques 110, 112, 114, 116 dans la figure 6 correspond à leur mise en parallèle, toutes les cathodes étant réunies au point de masse 601. Cette configuration se prête bien à une lecture séquentielle des signaux fournis par les capteurs en vue de leur traitement par multiplexage. En effet, elle ne demande qu'un seul interrupteur de lecture par capteur, à savoir les interrupteurs 602, 603, 604 et 605, respectivement, pour les capteurs 110, 112, 114, 116.

Si les capteurs sont des photo-diodes, il apparaît sur la figure 3 que l'énergie qu'elles sont susceptibles de fournir dans des conditions d'éclairement favorables est de l'ordre de quelques micro-watts. Cette énergie est en principe suffisante pour faire fonctionner les circuits de la montre, mais elle n'est disponible dans chaque capteur que sous une tension d'environ 0,5 V dans le meilleur des cas. Une telle tension est trop faible pour permettre la recharge directe de la batterie 404 de la montre représentée sur la figure 4.

Un arrangement en série des capteurs photo-électriques permet d'obtenir une tension plus élevée. Elle peut alors être suffisante pour recharger directement une batterie ou un accumulateur.

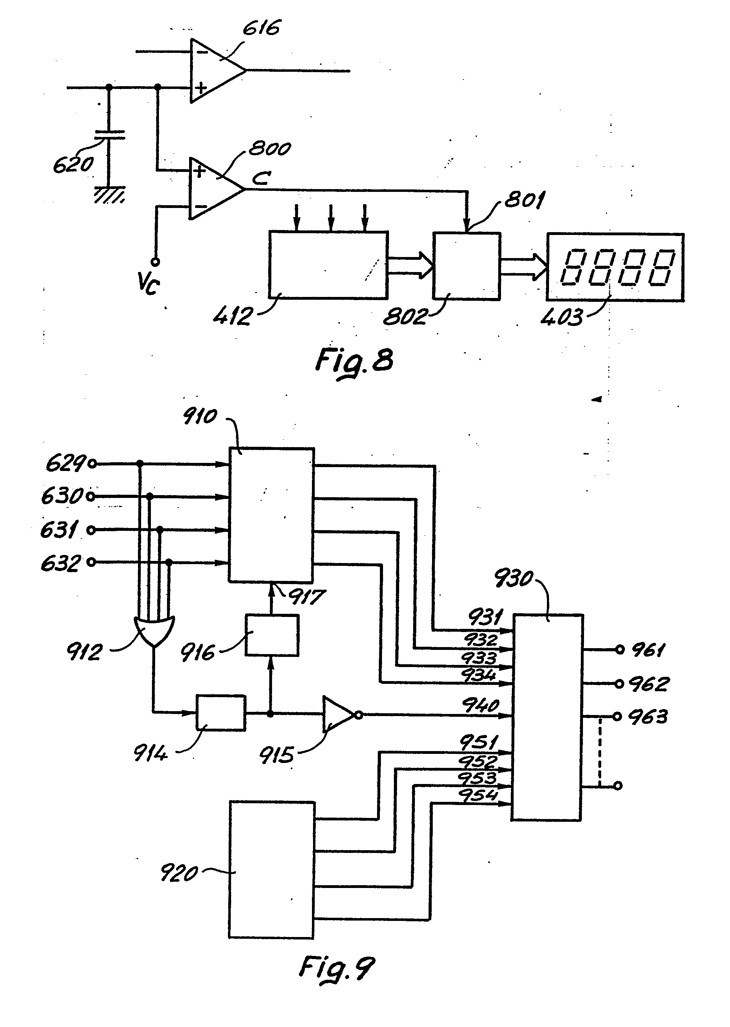

Une telle disposition des capteurs et le circuit associé vont maintenant être décrits dans une forme d'exécution préférentielle à quatre capteurs à l'aide du schéma de la figure 7. Dans ce dessin, la cathode d'un capteur 116 est reliée au point de masse 601 et son anode est connectée à la cathode d'un capteur 114.

L'anode du capteur 114 est reliée de même à la cathode d'un capteur 112. Enfin l'anode du capteur 112 est reliée à la cathode d'un capteur 110 dont l'anode 701 se trouve ainsi être à une tension égale à la somme des tensions de chaque capteur. La tension existant au point 701 est utilisée pour charger la batterie 404 au travers d'un circuit 702 classique et connu en soi, tel que celui décrit dans la demande de brevet suisse no 607813. Ce circuit permet de limiter le courant de charge dans la batterie 404 et d'éviter qu'elle ne se décharge lorsqu'un ou plusieurs capteurs sont obscurcis. Les circuits 401 et 402 sont reliés à la batterie 404 par une connexion 703. La source d'un transistor 704 est reliée au point 701 et le drain de ce transistor est connecté à la source d'un transistor 705. Le drain du transistor 705 est relié à l'entrée directe 606 de l'amplification 612. La source d'un transistor 708 est reliée à la cathode du capteur 110 et le drain de ce transistor est connecté à la source d'un transistor 709. Le drain du transistor 709 est relié au point 606. La source d'un transistor 706 est reliée au point de masse 601 et le drain de ce transistor est connecté au drain d'un transistor 707. La source du transistor 707 est reliée au drain du transistor 708. Un condensateur 724 relie les drains des transistors 704 et 707. Une résistance 720 relie les drains des transistors 704 et 708. La source d'un transistor 712 est reliée à la cathode du capteur 112 et le drain de ce transistor est connecté à la source d'un transistor 713. Le drain du transistor 713 est relié au point 606. La source d'un transistor 710 est relié au point de masse 601 et le drain de ce transistor est connecté au drain d'un transistor 711. La source du transistor 711 est reliée au drain du transistor 712. Un condensateur 725 relie les drains des transistors 708 et 711. Une résistance 721 relie les drains des transistors 708 et 712. La source d'un transistor 718 est reliée à la cathode du capteur 114 et le drain de ce transistor est connecté à la source d'un transistor 719. Le drain du transistor 719 est relié au point 606. La source d'un transistor 714 est reliée au pont de masse 601 et le drain de ce transistor est connecté au drain d'un transistor 715. La source du transistor 715 est reliée au drain du transistor 718. Un condensateur 726 relie les drains des transistors 712 et 715. Une résistance 722 relie les drains des transistors 712 et 718. Un condensateur 727 relie le drain du transistor 718 au point de masse 601. Les grilles des transistors 704, 707, 708, 711, 712, 715 et 718 sont toutes commandées par le signal logique $\bar{\Phi}$. De même, les grilles des transistors 705 et 706 sont commandés par le signal logique $\Phi_1$, les grilles des transistors 709 et 710 par le signal logique $\Phi_2$, les grilles des transistors 713 et 714 par le signal logique $\Phi_3$ et la grille du transistor 719 par le signal logique $\Phi_4$. La forme des signaux logiques $\bar{\Phi}$, $\Phi_1$, $\Phi_2$, $\Phi_3$ et $\Phi_4$ est celle représentée sur la figure 5 et leur amplitude est supposée être suffisante pour faire fonctionner chaque transistor en interrupteur, de la même façon que les transistors se trouvant dans le schéma de la figure 6. L'utilisation d'un circuit élévateur de tension est nécessaire pour obtenir l'amplitude requise pour ces signaux. Ce circuit élévateur de tension n'est pas représenté sur la figure 7, mais il est connu en soi et peut être implanté dans le circuit 402 de la montre. Les résistances 720, 721, 722 et 723 servent de charge aux capteurs et rendent superflue la résistance de charge unique 600.

La description du fonctionnement du circuit de la figure 7 sera faite en considérant d'abord comment est transmis, par exemple, le signal généré par le capteur 112 à l'amplificateur 612. En se référant au diagramme des signaux logiques de la figure 5, on voit qu'à l'instant $t'_1$, le signal $\bar{\Phi}$ passe au niveau logique haut, alors que le signal $\Phi_2$ est au niveau bas. Les interrupteurs 708, 711 et 712 passent donc de l'état ouvert à l'état fermé, tandis que les interrupteurs 709 et 710 restent ouverts, le niveau logique de $\Phi_2$ étant bas. La tension aux bornes du capteur 112 est ainsi appliquée au condensateur 725. La résistance de charge 721 permet d'optimiser la variation de la tension aux bornes du capteur en fonction de la variation de l'éclairement. A l'instant $t_2$, le niveau logique de $\bar{\Phi}$ passe au niveau bas et celui de $\Phi_2$ passe au niveau haut. Les commutateurs 708, 711 et 712 s'ouvrent et isolent le condensateur 725, chargé à la tension du capteur 112. Les interrupteurs 709 et 710 par contre se ferment. L'interrupteur 709 met une des électrodes du condensateur 725 au point de masse 601, tandis que l'interrupteur 709 transmet la tension de l'autre électrode à l'entrée 606 de l'amplificateur 612.

En considérant maintenant le circuit de la figure 7 globalement, on voit qu'à chaque niveau haut du signal logique $\bar{\Phi}$, les condensateurs 724, 725, 726 et 727 sont chargés respectivement aux tensions des capteurs 110, 112, 114 et 116. Les tensions de ces condensateurs sont ainsi transférées cycliquement, et dans le même ordre, à l'amplificateur 612 à l'aide des signaux logiques $\Phi_1$, $\Phi_2$, $\Phi_3$ et $\Phi_4$. Ces tensions sont ensuite traitées par le circuit de la figure 6 de la même manière que dans le cas du branchement en parallèle des capteurs.

Dans le cas représenté sur la fig. 4, où la montre est à affichage digital (cellules à cristaux liquides), le circuit de commande 401 peut remplir une autre fonction qui est de déconnecter automatiquement la cellule d'affichage 403, dans le but d'économiser du courant, lorsque l'éclairement ambiant est insuffisant. La fig. 8 montre une modification possible du circuit de commande 401 pour mettre en œuvre cette fonction.

Sur la fig. 8 on retrouve l'amplificateur 616 et le condensateur 620 de la fig. 6 qui mémorise la valeur moyenne $\bar{V}$ représentative de l'intensité de l'éclairage ambiant. On ajoute au circuit un amplificateur différentiel 800 monté en comparateur. Son entrée directe, marquée +, est reliée à l'entrée directe de l'amplificateur différentiel 616. Elle reçoit donc la tension $\bar{V}$. L'entrée inverse, marquée −, de l'amplificateur 800 reçoit une tension de référence $V_c$. La valeur de $V_c$ correspond au seuil d'intensité lumineuse en deçà duquel la cellule d'affichage n'est plus lisible. L'amplificateur 800 délivre un signal C de niveau logique 1 si $\bar{V}$ est supérieur à $V_c$ et de niveau logique zéro dans le cas contraire.

Le signal C est appliqué à l'entrée de commande 801 d'un circuit 802, placé sur la ligne joignant le décodeur 412 à l'affichage 403. Le circuit 802 a la fonction d'un interrupteur, réalisé de façon connue à l'aide de transistors MOS ou de portes de transmissions, qui coupe les signaux d'attaque de la cellule d'affichage lorsque le signal C vaut zéro.

Dans d'autres modes de réalisation, le circuit 802 pourrait être placé entre le dispositif d'affichage 403 et son alimentation qui comprend la pile 404. En outre, le dispositif d'affichage 403 peut être constitué par n'importe quel dispositif d'affichage passif électro-optique, par exemple une cellule à cristaux liquides.

Si l'on revient à la fig. 4, on voit que le circuit garde-temps 402 comprend en fait un ensemble pour élaborer l'information de temps présent constitué essentiellement par la base de temps 405, 406 et par le diviseur 407 qui délivre les impulsions pour que le dispositif d'affichage 403 affiche en fonctionnement normal le temps présent. Le circuit 402 comprend de plus le circuit d'élaboration d'informations 422 qui, à partir des signaux de commande; élabore des informations qui servent à modifier ce qu'affiche le dispositif 403 lorsqu'une fonction autre que l'affichage du temps présent est sélectionnée par l'utilisateur. Toutes les montres comportent au moins une autre fonction qui est la correction de l'heure. C'est ce qui et représenté en détails sur la fig. 4. La montre est complétée par un circuit de sélection de fonctions. Dans le cas de la fig. 4, le circuit de sélection se réduit au commutateur 420 qui permet de commander soit l'affichage du temps présent, soit la correction de ce temps.

Cependant, une montre peut comporter d'autres fonctions que la correction. Il faut alors que le circuit de sélection puisse commander la mise en œuvre de ces fonctions. Il s'agit par exemple de l'affichage du quantième, du mois, etc.

Dans l'exemple du circuit d'une montre représenté par la fig. 4, les signaux logiques délivrés par les sorties 629 à 632 du circuit de commande 401 sont traités par le circuit garde-temps 402 pour fournir une information sur le sens de déplacement du doigt sur les capteurs photo-électriques 110–116 ainsi que sur le nombre de capteurs obstrués par le doigt lors de son déplacement. Les capteurs jouent donc un rôle analogue à celui d'une molette dont on discrimine le sens et l'angle de rotation.

La fig. 9 illustre un autre type de traitement des signaux délivrés par les sorties 629 à 632 pour réaliser un circuit de sélection. Ce traitement a pour but d'obtenir un signal de sélection sous forme codée, permettant de choisir une certaine fonction dans le circuit garde-temps 402 de la montre. Le code est défini par le marquage d'un ou plusieurs capteurs dans un certain ordre. Par exemple, un premier signal sera codé en marquant, l'un après l'autre, les capteurs 110 et 116; un autre signal correspondra au masquage des capteurs 110, 114 et 116. En attribuant un rang à chaque capteur, à tout code correspondra un nombre binaire. Dans le premier cas on aura, par exemple, le nombre 1001 et dans le second cas le nombre 1011. Pour éviter toute confusion avec les codes générés par le déplacement du doigt sur les capteurs et correspondant à un fonctionnement déjà décrit, les codes de sélection ne doivent pas être formés de capteurs obscurcis, tous adjacents. Par exemple les codes 1100 ou 0111 sont à proscrire.

Pour atteindre ce but, le signal de sélection, entré par l'utilisateur à l'aide des capteurs, est comparé à l'ensemble des instructions codées reconnaissables par la montre. Chaque instruction correspond à un mode particulier de fonctionnement de la montre. Si le signal est reconnu, un ordre correspondant à l'instruction choisie sera transmise au circuit garde-temps 402, lequel sélectionnera à son tour le mode désiré. Pour donner un exemple, on peut se reporter à la fig. 4. La fonction du contact 420 dans ce schéma est de faire basculer le flip-flop 419 à chaque pression, faisant passer la montre du mode d'indication de l'heure au mode correction et inversement. Cette fonction du contact 420 peut aussi être obtenue en appliquant à l'entrée du flip-flop 419 une impulsion qui le fasse basculer chaque fois que le capteur 110 est obstrué.

Un circuit de sélection est représenté à titre d'exemple par la fig. 9. Il comprend une première mémoire 910 à quatre bits du type SET-RESET qui reçoit sur chacune de ses entrées un des signaux délivrés par les sorties 629 à 632 du circuit 401. Ces mêmes sorties sont également reliées aux quatre entrées d'une porte OU référencée 912. La sortie de cette porte est reliée à l'entrée d'une bascule monostable 914 de constante de temps $\tau_1$. Une transition du niveau logique bas au niveau logique haut à l'entrée du monostable 914 fait apparaître aussi un niveau logique haut à sa sortie pendant le temps $\tau_1$. La sortie du monostable retourne au niveau bas après le temps $\tau_1$. Lorsque l'entrée passe au niveau bas, la sortie passe aussi au niveau bas après un temps $\tau_1$, pour autant que l'entrée n'ait pas changée d'état entre temps. Ainsi de brèves variations, inférieures à $\tau_1$ de l'entrée, n'ont aucune influence sur la sortie lorsqu'elle est au niveau haut. Le temps $\tau_1$ correspond à celui nécessaire au doigt pour passer d'un capteur à un autre dans un mouvement lent. La sortie de la bascule monostable 914 est reliée d'une part, à l'entrée d'un inverseur 915 et, d'autre part, à l'entrée d'une seconde bascule monostable 916. Une transition du niveau logique haut au niveau bas à l'entrée de ce second monostable fait apparaître aussi un niveau haut à sa sortie; la sortie se maintient dans cet état durant un temps $\tau_2$, beaucoup plus court que $\tau_1$, après le temps $\tau_2$, la sortie passe au niveau logique bas. Sa sortie du monostable 916 est reliée à une entrée 917 de remise à zéro de la mémoire 910. Une mémoire morte 920 contient les codes de sélection des différentes fonctions de la montre. Les sorties de cette mémoire sont reliées aux entrées 951 à 954 d'une mémoire morte de décodage 930. Aux entrées 931 à 940 de cette mémoire sont reliées les sorties de la mémoire 910. Enfin, la mémoire 930 possède une entrée d'activation 940, à laquelle est reliée la sortie de l'inverseur 915, et des sorties 961, 962, 963, etc. dont le nombre correspond à la capacité de la mémoire 910, identique à celle de la mémoire 920.

La mèmoire 930 permet, par décodage, de comparer l'état de la mémoire 910 aux différents états mémorisés dans la mémoire 920, chacun correspondant à un code de sélection. Lorsqu'il y a identité, et que l'entrée d'activation 940 est au niveau logique haut, une ou plusieurs des sorties 961, 962, 963 etc. passe au niveau logique haut, les autres sorties restant au niveau logique bas. Dans le cas contraire, si 'état de la mémoire 910 ne correspond à aucun des états de la mémoire 920, le niveau logique bas apparaît sur toutes les sorties.

Enfin, lorsque l'entrée d'activation 940 de la mémoire 930 se trouve au niveau logique bas, les sorties ne sont pas influencées par l'état des entrées.

Le fonctionnement du circuit de la fig. 9 est le suivant. Initialement, ces entrées 629 à 632 et les sorties des circuits 912, 914 et 916 sont toutes au niveau logique bas. Les sorties de la mémoire 910 sont au niveau logique bas. L'entrée d'activation 940 est alors au niveau logique haut, puisqu'elle correspond à la sortie de l'inverseur 915. Les sorties 961, 962, 963 etc. de la mémoire 930 se trouvent également dans l'état correspondant à la sélection précédente. Si l'on désire introduire maintenant une nouvelle sélection de mode de fonctionnement de la montre en obstruant par exemple le capteur 110 et 116, ce qui correspond au code 1001, on commencera par obstruer le capteur 110, ce qui fera passer l'entrée 629 au niveau logique haut. Les sorties de la porte OU 912 et des bascules 914 et 916 passeront également du niveau logique haut au niveau logique bas et puis retournent au niveau haut durant l'entrée d'un code de sélection.

Puis lorsque le doigt est retiré des capteurs, toutes les entrées 629 à 632 retournent au niveau bas ainsi que la sortie de la porte OU refermée 912.

La sortie de la bascule 914 passe alors au niveau bas et l'entrée 940 de la mémoire 930 au niveau haut, après le temps $\tau_1$. Durant la transition, l'entrée d'activation 940 étant au niveau haut, la mémoire 930 décodera le code de sélection introduit et fera apparaître un signal haut sur l'une des sorties 961, 962, 963, etc. qui servira à commander le circuit 402.

La transition du niveau haut ou niveau bas du circuit 914 met la sortie du circuit 917 au niveau logique haut pendant le temps $\tau_2$. Après ce temps $\tau_2$ la sortie retourne au niveau bas. Cette transition remet la mémoire 910 à zéro et met toutes les sorties au niveau bas.

**Revendications**

1. Montre électronique à organe de commande fixe comportant:
   — un circuit garde-temps (402);
   — un dispositif d'affichage du temps (403), commandé par ledit circuit (402);
   — des moyens de commande manuelle (401, 110, 112, 114, 116) pour fournir des signaux de commande (629, 630, 631, 632) audit circuit; et
   — une source électrique (404) d'alimentation du circuit garde-temps (402), du dispositif d'affichage (403) et des moyens de commande (401), caractérisée en ce que lesdits moyens de commande comportent un ensemble formant capteur photo-électrique (110, 112, 114, 116) disposé pour recevoir la lumière ambiante et fournissant un signal représentatif de l'intensité de ladite lumière et dont l'éclairement peut être interrompu manuellement pour générer lesdits signaux de commande (629, 630, 631, 632).

2. Montre électronique selon la revendication 1, caractérisée en ce que ledit ensemble formant capteur photo-électrique consiste en un seul capteur (116).

3. Montre électronique selon la revendication 2, caractérisée en ce que lesdits moyens de commande (401, 116) comportent, de plus, un circuit de compensation (639) connecté pour recevoir le signal fourni par le capteur (116) et permettant de générer lesdits signaux de commande (632) de manière sensiblement indépendante de l'intensité de la lumière ambiante.

4. Montre électronique selon la revendication 3, caractérisée en ce que ledit circuit de compensation (639) comprend:

— des moyens (620) pour obtenir un signal électrique moyen $(\overline{V})$, représentatif de la moyenne temporelle du signal fourni par le capteur; et

— un comparateur (616) pour comparer périodiquement le signal du capteur audit signal moyen $(\overline{V})$ et fournir un signal logique de commande (632) lorsque l'écart entre le signal du capteur et le signal moyen $(\overline{V})$ dépasse une valeur prédéterminée.

5. Montre électronique selon la revendication 4, caractérisée en ce que les moyens pour obtenir ledit signal électrique moyen comportent un filtre passe-bas à condensateurs commutés (618, 620).

6. Montre électronique selon la revendication 1, caractérisée en ce que lesdits moyens de commande (401, 110, 112, 114, 116) comportent une pluralité de capteurs photo-électriques (110, 112, 114, 116) dont l'éclairement peut être interrompu manuellement de façon individuelle pour générer lesdits signaux de commande (629, 630, 631, 632).

7. Montre électronique selon la revendication 6, caractérisée en ce que lesdits capteurs photo-électriques (110, 112, 114, 116) sont des photo-diodes.

8. Montre électronique selon la revendication 6, caractérisée en ce que lesdits moyens de commande comportent, de plus, un circuit de compensation (639) connecté pour recevoir les signaux fournis par les capteurs (110, 112, 114, 116) et permettant de générer lesdits signaux de commande (629, 630, 631, 632) de manière sensiblement indépendante de l'intensité de la lumière ambiante, et des moyens de multiplexage (602 à 605) pour appliquer cycliquement le signal fourni par chaque capteur (110, 112, 114, 116) au circuit de compensation.

9. Montre électronique selon la revendication 6, caractérisée en ce que lesdits capteurs (110, 112, 114, 116) sont reliés en série (fig. 7).

10. Montre électronique selon la revendication 9, caractérisée en ce qu'elle comporte des moyens (702), connectés aux bornes extrêmes desdits capteurs (110, 112, 114, 116) reliés en série, pour recharger ladite source d'alimentation (404).

11. Montre selon la revendication 8, caractérisée en ce que ledit circuit de compensation comprend:

— des moyens (618, 620) pour élaborer un signal électrique moyen $(\overline{V})$ représentativ de la moyenne temporelle des signaux fournis par les capteurs; et

— un comparateur (616) pour comparer périodiquement audit signal électrique moyen $(\overline{V})$ successivement les signaux délivrés par lesdits capteurs et pour fournir un signal logique de commande à chaque fois que l'écart entre le signal d'un desdits capteurs et le signal moyen $(\overline{V})$ dépasse une valeur donnée.

12. Montre selon l'une quelconque des revendications 4 et 11, caractérisée en ce que le dispositif d'affichage du temps (403) est un dispositif d'affichage passif électro-optique et en ce qu'elle comprend en outre, un circuit de comparaison (800) pour comparer ledit signal électrique moyen ($\overline{V}$ à une valeur de référence $V_c$) représentative d'un niveau d'intensité de la lumière ambiante, et pour délivrer un signal d'interruption (C) lorsque ledit signal moyen est inférieur à ladite valeur, et des moyens (802) pour interrompre l'alimentation dudit dispositif d'affichage (403) en réponse audit signal d'interruption (fig. 8).

13. Montre électronique selon l'une quelconque des revendications 6 à 8, caractérisée en ce qu'elle comprend de plus des moyens pour sélectionner une parmi une pluralité de fonctions y compris l'affichage du temps, en ce que les capteurs photo-électriques (110, 112, 114, 116) sont disposés pour que leurs surfaces sensibles puissent être balayées dans un premier et dans un deuxième sens; et en ce que ledit circuit garde-temps comprend des moyens (405, 406, 407) pour engendrer un signal de temps présent afin d'afficher une information de temps présent, et des moyens (442) pour élaborer des instructions pour modifier l'information affichée en réponse auxdits moyens de sélection et auxdites instructions, lesdits moyens d'élaboration d'instructions comprenant des moyens (417, 418, 414) répondant auxdits signaux de commande (629, 630, 631, 632) pour détecter ledit sens de balayage afin d'élaborer un premier signal représentatif du sens de balayage et des moyens (418, 413) répondantr auxdits signaux de commande (629, 630, 631, 632) pour détecter le nombre de capteurs obstrués dans le même sens de balayage afin d'élaborer un deuxième signal représentatif dudit nombre et des moyens (410, 411) répondant auxdits premier et deuxième signal pour fournir lesdites instructions (fig. 4).

14. Montre électronique selon l'une quelconque des revendications 6 à 8, caractérisée en ce qu'elle comprend en outre des moyens pour sélectionner une parmi une pluralité de fonctions y compris l'affichage du temps présent, lesdits moyens de sélection comprenant des moyens (920) pour mémoriser une pluralité de configurations de signaux de commande prédéterminées, chaque configuration étant associée à l'une des fonctions, des moyens (910, 930) répondant auxdits signaux de commande (629, 630, 631, 632) pour comparer lesdits signaux de commande auxdites configurations prédéterminées et des moyens (930, 961, 962, 963) pour élaborer un signal de sélection de fonction en réponse à ladite comparaison (fig. 9).

**Pantentansprüche**

1. Elektronische Uhr mit festem Steuerorgan umfassend:

— einen Zeithaltekreis (402);

— eine Zeitanzeigeeinrichtung (403), die von dem genannten Zeithaltekreis (402) gesteuert ist;

— manuelle Steuermittel (401, 110, 112, 114, 116) zum Liefern von Steuersignalen (629, 630, 631, 632) an den genannten Kreis und

– eine elektrische Quelle (404) für die Speisung des Zeithaltekreises (402), der Anzeigeeinrichtung (403) und der Steuermittel (401),

dadurch gekennzeichnet, dass die genannten Steuermittel eine Baugruppe umfassen, gebildet von einem fotoelektrischen Fühler (110, 112, 114, 116), angeordnet zum Empfangen von Umgebungslicht und ausgebildet zum Liefern eines Signals, das repräsentativ ist für die Intensität des genannten Lichtes und dessen Ausleuchtung manuell unterbrochen werden kann zum Erzeugen der genannten Steuersignale (629, 630, 631, 632).

2. Elektronische Uhr nach Anspruch 1, dadurch gekennzeichnet, dass die genannte Baugruppe, die den fotoelektrischen Fühler bildet, aus einem einzigen Fühler (116) besteht.

3. Elektronische Uhr nach Anspruch 2, dadurch gekennzeichnet, dass die genannten Steuermittel (401, 116) ferner einen Kompensationskreis (639) umfassen, angeschlossen zum Empfang des von dem Fühler (116) gelieferten Signals zum Ermöglichen der Erzeugung der genannten Steuersignale (632) in einer im wesentlichen von der Intensität des Umgebungslichtes unabhängigen Weise.

4. Elektronische Uhr nach Anspruch 3, dadurch gekennzeichnet, dass der genannte Kompensationskreis (639) umfasst:

– Mittel (620) zum Ableiten eines mittleren elektrischen Signals (V̄), repräsentativ für das zeitliche Mittel des von dem Fühler gelieferten Signals; und

– einen Komparator (616) zum periodischen Vergleich des Fühlersignals mit dem mittleren Signal (V̄) und zum Liefern eines Logiksteuersignals (632), sobald die Abweichung zwischen dem Fühlersignal und dem mittleren Signal (V̄) einen vorgegebenen Wert übersteigt.

5. Elektronische Uhr nach Anspruch 4, dadurch gekennzeichnet, dass die Mittel zum Ableiten des genannten elektrischen mittleren Signals ein Bandpassfilter mit kommutierten Kondensatoren (618, 620) umfassen.

6. Elektronische Uhr nach Anspruch 1, dadurch gekennzeichnet, dass die genannten Steuermittel (401, 110, 112, 114, 116) eine Mehrzahl von fotoelektrischen Fühlern (110, 112, 114, 116) umfassen, deren Ausleuchtung manuell in individueller Weise unterbrechbar ist zum Erzeugen der genannten Steuersignale (629, 630, 631, 632).

7. Elektronische Uhr nach Anspruch 6, dadurch gekennzeichnet, dass die genannten fotoelektrischen Fühler (110, 112, 114, 116) Fotodioden sind.

8. Elektronische Uhr nach Anspruch 6, dadurch gekennzeichnet, dass die genannten Steuermittel zusätzlich einen Kompensationskreis (639) umfassen, angeschlossen zum Empfang der Signale, die von den Fühlern (110, 112, 114, 116) geliefert werden zum Ermöglichen der Erzeugung der genannten Steuersignale in im wesentlichen von der Umgebungslichtintensität unabhängiger Weise sowie Multiplexmittel (602 bis 605) umfassen zum zyklischen Anlegen der von jedem Fühler (110, 112, 114, 116) gelieferten Signale an den Kompensationskreis.

9. Elektronische Uhr nach Anspruch 6, dadurch gekennzeichnet, dass die genannten Fühler (110, 112, 114, 116) in Serie geschaltet sind (Fig. 7).

10. Elektronische Uhr nach Anspruch 9, dadurch gekennzeichnet, dass sie Mittel (702) umfasst, angeschlossen an die extremen Klemmen der genannten Fühler (110, 112, 114, 116), die in Serie gelegt sind zum Aufladen der genannten Speisequelle (404).

11. Elektronische Uhr nach Anspruch 8, dadurch gekennzeichnet, dass der genannte Kompensationskreis umfasst:

– Mittel (618, 620) zum Erzeugen eines mittleren elektrischen Signals (V̄), repräsentativ für das zeitliche Mittel der von den Fühlern gelieferten Signale und

– einen Komparator (616) zum periodischen aufeinanderfolgenden Vergleich der von den genannten Fühlern gelieferten Signale mit dem elektrischen mittleren Signal (V̄) und zum Liefern eines logischen Steuersignals immer dann, wenn die Abweichung zwischen dem Signal eines der genannten Fühler und dem mittleren Signal (V̄) einen gegebenen Wert übersteigt.

12. Elektronische Uhr nach den Ansprüchen 4 und 11, dadurch gekennzeichnet, dass die Zeitanzeigeeinrichtung (403) eine passive elektro-optische Anzeigeeinrichtung ist und dass sie ferner einen Vergleichskreis (800) umfasst zum Vergleichen des genannten mittleren elektrischen Signals (V̄) mit dem Referenzwert (V$_c$), repräsentativ für den Intensitätspegel des Umgebungslichtes und zum Erzeugen eines Unterbrechungssignals (C), sobald das genannte mittlere Signal kleiner ist als der genannte Wert sowie Mittel (802) zum Unterbrechen der Speisung der genannten Anzeigeeinrichtung (403) im Anprechen auf das genannte Unterbrechungssignal (Fig. 8).

13. Elektronische Uhr nach einem der Ansprüche 6 bis 8, dadurch gekennzeichnet, dass sie zusätzlich Mittel umfasst zum Auswählen einer von einer Mehrzahl von Funktionen einschliesslich der Zeitanzeige, dass die fotoelektrischen Fühler (110, 112, 114, 116) angeordnet sind derart, dass ihre empfindlichen Oberflächen in einer ersten und in einer zweiten Richtung überstrichen werden können und dass der genannte Zeithaltekreis Mittel (405, 406, 407) umfasst zum Erzeugen eines Präsenzzeitsignals für die Anzeige einer Präsenzzeitinformation sowie Mittel (422) zum Erzeugen von Befehlen für die Modifikation der angezeigten Information in Abhängigkeit von den genannten Auswählmitteln und den genannten Befehlen, wobei die genannten Befehlserzeugungsmittel Mittel (417, 418, 414) umfassen, anprechend auf die genannten Steuersignale (629, 630, 631, 632) zum Ermitteln der genannten Abtastrichtung zwecks Erzeugung eines ersten Signals, repräsentativ für die Abtastrichtung und Mittel (418, 413), anprechend auf die genannten Steuersignale (629, 630, 631, 632) zum Ermitteln der Anzahl von bei derselben Abtastrichtung überdeckten Fühler zwecks Erzeugung eines zweiten Signals, repräsentativ für diese Anzahl und Mittel (410, 411), ansprechend ausgebildet auf das genannte erste und das genannte zweite Signal zum Liefern der genannten Befehle (Fig. 4).

14. Elektronische Uhr nach einem der Ansprüche 6 bis 8, dadurch gekennzeichnet, dass sie ferner Mittel zum Auswählen einer unter einer Mehrzahl von Funktionen einschliesslich der Präsenzzeitanzeige umfasst, welche Auswählmittel Mittel (920) umfassen zum Abspeichern einer Mehrzahl von vorgegebenen Kommandosignal-Konfigurationen, wobei jede Konfiguration einer der Funktionen zugeordnet ist, Mittel (910, 930), die auf die genannten Kommandosignale (629, 630, 631, 632) ansprechen zum Vergleichen der genannten Kommandosignale mit den genannten vorgegebenen Konfigurationen und Mittel (930, 961, 962, 963) zum Erzeugen eines Funktionswählsignals in Abhängigkeit von dem genannten Vergleich (Fig. 9).

**Claims**

1. Electronic watch with a stationary controller comprising:
   - a time keeping circuit (402);
   - a time display arrangement (403) controlled by said circuit (402);
   - manual control means (401, 110, 112, 114, 116) for providing control signals (629, 630, 631, 632) to said circuit; and
   - an electrical energization source (404) for the time keeping circuit (402), the display arrangement (403) and the control means (401),
   characterized in that said control means include an assembly forming a photo electric sensor (110, 112, 114, 116) arranged to receive ambient light and providing a signal representative of the intensity of said light and of which the light reception can be manually interrupted in order to generate said control signals (629, 630, 631, 632).

2. Electronic watch according to claim 1 characterized in that the assembly forming the photo electric sensor consists of a single sensor (116).

3. Electronic watch according to claim 2 characterized in that said control means (401, 116) additionally comprise a compensating circuit (639) connected to receive the signal provided by the sensor and enabling the generation of said control signals (632) in a manner substantially independent from the intensity of the ambient light.

4. Electronic watch according to claim 3 characterized in that said compensating circuit (639) includes:
   - means (620) for obtaining an averaged electrical signal $(\overline{V})$ representative of the time averaged signal provided by the sensor; and
   - a comparator (616) for periodically comparing the signal from the sensor with said averaged signal $(\overline{V})$ and providing a logic control signal (632) when the spread between the signal from the sensor and the averaged signal $(\overline{V})$ exceeds a predetermined value.

5. Electronic watch according to claim 4 characterized in that the means for obtaining said averaged electrical signal comprises a low pass filter of switched capacitors (618, 620).

6. Electronic watch according to claim 1 characterized in that said control means (401, 110, 112, 114, 116) comprise a plurality of photo electric sensors (110, 112, 114, 116) the light reception of which can be manually interrupted individually so as to generate said control signals (629, 630, 631, 632).

7. Electronic watch according to claim 6 characterized in that said photo electric sensors (110, 112, 114, 116) are photo diodes.

8. Electronic watch according to claim 6 characterized in that said control means additionally comprise a compensating circuit (639) connected so as to receive the signals provided by the sensors (110, 112, 114, 116) and enabling the generation of said control signals (629, 630, 631, 632) in a manner substantially independent from the intensity of the ambient light and multiplexing means (602–605) for cyclically applying the signal provided by each sensor (110, 112, 114, 116) to the compensating circuit.

9. Electronic watch according to claim 6 characterized in that said sensors (110, 112, 114, 116) are coupled in series (fig. 7).

10. Electronic watch according to claim 9 characterized in that it comprises means (702) connected to the end terminals of said sensors (110, 112, 114, 116) coupled in series for recharging said energization source (404).

11. Watch according to claim 8 characterized in that said compensating circuit includes:
   - means (618, 620) for developing an averaged electrical signal $(\overline{V})$ representative of the time averaged signals provided by the sensors; and
   - a comparator (616) for periodically comparing successively the signals provided by said sensors with said averaged electrical signal $(\overline{V})$ and for providing a logic control signal each time that the spread between the signal from any one of said sensors and the averaged signal $(\overline{V})$ exceeds a given value.

12. Watch according to either of claims 4 and 11 characterized in that the time display arrangement (403) is a passive electro-optic display device and further comprising a comparison circuit (800) for comparing said averaged electrical signal $(\overline{V})$ with a reference value $(V_c)$ representative of an intensity level of the ambient light and for providing an interrupt signal (C) when said averaged signal is less than said value, and means for interrupting said display device in response to said interrupt signal (fig. 8).

13. Electronic watch according to any of claims 6–8 characterized in that it further comprises means for selecting one among a plurality of functions including time display, in that the photoelectric sensors (110, 112, 114, 116) are arranged so that their receptive surfaces may be swept in a first and a second sense; in that said time keeping circuit comprises means (405, 406, 407) for generating a real time signal in order to display time of day, and means (422) for developing instructions for modifying the displayed information in response to said selecting means and to said instructions, said means for developing instructions means (417, 418, 414) responding to said control signals (629, 630, 631, 632) for detecting the sweeping sense in order to develop a first signal representative of the sweeping sense and means (418, 419) responding to said control signals (629, 630, 631, 632) for detecting the number of sensors obstructed in the same sweeping sense in order to develop a second signal representative of said number, and means (410, 411) responding to said first and second signal for providing said instructions (fig. 4).

14. Electronic watch according to any of claims 6–8 characterized in that it further comprises means for selecting one among a plurality of functions including display of the time of day, said selection means comprising means (920) for memorizing a plurality of predetermined configurations of control signals, each configuration being associated with one of the functions, means (910, 930) responsive to said control signals (629, 630, 631, 632) for comparing said control signals with said predetermined configurations and means (930, 961, 962, 963) for developing a function selection signal in response to said comparison (fig. 9).

Fig. 1

Fig.2

Fig.3

Fig.4

Fig.5

Fig.7

Fig.6

Fig.8

Fig.9